# EUROPEAN PATENT SPECIFICATION

(11) **EP 1 618 586 B1**
(45) Date of publication and mention of the grant of the patent: **21.06.2017**
(21) Application number: 04750140.8
(22) Date of filing: 15.04.2004
(51) Int. Cl.: H01J 37/00, B22F 3/16, B22F 3/24, B21J 1/02, B21J 5/00, B21C 23/01, B21C 23/00, C23C 14/34, C22C 1/10, C22C 27/04, C22F 1/18, C22C 32/00, H05H 6/00, C22B 34/34, C22C 1/02

(54) **MOLYBDENUM ALLOY X-RAY TARGETS HAVING UNIFORM GRAIN STRUCTURE**
MOLYBDENLEGIERUNGS-RÖNTGENTARGETS MIT GLEICHFÖRMIGER KORNSTRUKTUR
CIBLES DE RAYONS X EN ALLIAGE DE MOLYBDENE AYANT UNE STRUCTURE A GRAINS UNIFORME

(30) Priority: 23.04.2003 US 464755 P
(43) Date of publication of application: 25.01.2006
(73) Proprietor: H.C. Starck Inc., Newton, MA 02461 (US)
(72) Inventor: DAILY, James, Marshall, MI 49068 (US); LEMON, Brad, Battle Creek, MI 49014 (US); HIRT, Joseph, Coldwater, MI 49036 (US); KUMAR, Prabhat, Framingham, MA 01701 (US); GILLE, Gerhard, 38640 Goslar (DE)
(74) Representative: Lux, Berthold
(86) International application number: PCT/US2004/011554
(87) International publication number: WO 2004/095501

(56) References cited:
- EP-A- 0 055 828
- WO-A-02/070765
- WO-A-2004/022801
- GB-A- 938 546
- US-A- 4 077 811
- US-A- 5 868 876
- US-A1- 2001 001 401
- US-A1- 2001 014 568
- US-A1- 2001 036 249
- US-A1- 2003 052 000
- US-B1- 6 707 883

## Description

### BACKGROUND OF THE INVENTION

X-ray producing devices are extremely valuable tools that are used in a wide variety of applications, both industrial and medical. For example, such equipment is commonly used in areas such as diagnostic and therapeutic radiology; semiconductor manufacture and fabrication; and materials analysis and testing.

While used in a number of different applications, the basic structure and operation of x-ray devices is similar. X-rays are produced when electrons are generated, accelerated to a high speed, and then stopped abruptly. Typically, this entire process takes place within a vacuum formed x-ray generating tube. An x-ray tube ordinarily includes three primary elements: a cathode assembly, which is the source of electrons; an anode, which is axially spaced apart from the cathode and oriented so as to receive electrons emitted by the cathode; and some mechanism for applying a high voltage for driving the electrons from the cathode to the anode. Usually, the cathode assembly is composed of a metallic cathode head having a cathode cup. Disposed within the cathode cup is a filament that, when heated via an electrical current, emits electrons.

The three x-ray tube elements are usually positioned within an evacuated glass tube and connected within an electrical circuit. The electrical circuit is connected so that the voltage generation element can apply a very high voltage (ranging from about ten thousand to in excess of hundreds of thousands of volts) between the anode and the cathode. This high voltage differential causes the electrons that are emitted from the cathode filament to accelerate at a very high velocity towards an x-ray "target" positioned on the anode in the form of a thin stream, or beam. The x-ray target includes a plate with a focal track. When the electrons strike the target surface, the kinetic energy of the striking electron beam is converted to electromagnetic waves of very high frequency, i.e., x-rays. The resulting x-rays emanate from the anode target surface, and are then collimated through a window formed in the x-ray device for penetration into an object, such as an area of a patient's body.

Unfortunately, known processes for making plates have limitations that have prevented artisans from developing a simple effective process and for quickly effectively making plates useful in x-ray targets. A particularly limiting disadvantage of known single forging processes, for instance, is that such processes are wasteful and inefficient, making them costly and impractical to implement. Known processes make products have poor uniform grain size. Poor uniformity in grain size interferes with the performance of X-ray anodes. Also, known processes produce anodes having poor temperature properties.

For the foregoing reasons, there is a need to develop a process that produces x-ray targets having uniform properties.

For the foregoing reasons, there is a need to develop a process that produces x-ray targets having uniform properties.

### SUMMARY OF THE INVENTION

The invention relates to a process for making a cross-directionally worked molybdenum plate. The plate is preferably used in an X-ray target so that the plate functions as an anode. The process involves (a) reducing ammonium molybdate and forming molybdenum, metal powder; (b) consolidating a molybdenum component made of molybdenum metal powder and an alloying element to a first workpiece, the alloying element being selected from the group consisting of titanium, zirconium, hafnium, carbon, lanthanum oxide, and combinations thereof; (c) thermally treating the first workpiece and subjecting the workpiece to thermo-mechanical forces in a first direction, and thereby forming a second workpiece; (d) thermally treating the second workpiece and subjecting the second workpiece to thermo-mechanical forces in a second direction that is different from the first direction by upset forging by a closed die forging process with a closed die that is dimensioned to form a plate ; (e) subjecting the thermomechanically treated second workpiece to a recrystallization heat treatment step, and thereby forming a heat-treated cross-directionally worked workpiece; and (f) subjecting the heat-treated, cross-directionally worked workpiece to a slicing step or a machining step, and thereby forming the cross-directionally worked molybdenum plate, wherein in step d), the closed die is further dimensioned to include a mold for a stem so that the plate formed by the process in step e) further comprises a stem. In one embodiment, the invention relates to an X-ray target made by such a process, in which the target includes a plate and a stem attached to the plate.

### DESCRIPTION OF THE FIGURES

These and other features, aspects, and advantages of the present invention will become better understood with reference to the following description and appended claims, where:
Fig. 1 is a schematic showing how a billet/ingot can be extruded in accordance to the invention;
Figs. 2 (a) and 2 (b) are a schematic showing how the first workpiece can be upset forged in accordance to the invention;
Fig. 3(a) is a view of the second workpiece generated during the upset forging operation with removal of centering disk affected material at A;
Fig. 3(b) is a view of the second workpiece formed from upset forging and a plate that can be sliced from the billet;
Fig. 4 is a side view showing a workpiece being subjected to hammer forging;
Fig. 5 shows the second workpiece formed from a workpiece that is subjected to hammer forging; and
Fig. 6 is a side view of a stem that can be attached to the plate made in accordance to the invention.

### DESCRIPTION OF THE INVENTION

The cross-directionally worked molybdenum plate is generally made by a process that (a) reduces ammonium molybdate and forming molybdenum metal powder; (b) consolidates a molybdenum component made of molybdenum metal powder and an alloying element to a first workpiece, the alloying element being selected from the group consisting of titanium, zirconium, hafnium, carbon, lanthanum oxide, and combinations thereof; (c) thermally treats the first workpiece and subjecting the workpiece to thermo-mechanical forces in a first direction, and thereby forming a second workpiece; (d) thermally treats the second workpiece and subjecting the second workpiece to thermo-mechanical forces in a second direction that is different from the first direction by upset forging by a closed die forging process with a closed die that is dimensioned to form a plate ; (e) subjects the thermomechanically treated second workpiece to a recrystallization heat treatment step, and thereby forming a heat-treated cross-directionally worked workpiece; and (f) subjects the heat-treated, cross-directionally worked workpiece to a slicing step or a machining step, and thereby forms the cross-directionally worked molybdenum plate, wherein in step d), the closed die is further dimensioned to include a mold for a stem so that the plate formed by the process in step e) further comprises a stem. The molybdenum metal powder is made by reducing ammonium molybdate by any suitable process. Generally, this is done through a conventional hydrogen reduction process. The process consolidates a molybdenum component including molybdenum metal powder and an alloying element to a first workpiece. In one embodiment, the molybdenum component is consolidated into the first workpiece by a powder metallurgical technique. Such a process generally involves the steps of cold isostatic pressing of the molybdenum metal powder and any alloying components into a "green" preform of the first workpiece. In another embodiment, the molybdenum component is consolidated into the first workpiece by a melt casting technique. Such a process may involve vacuum arc casting, ebeam melting, or plasma arc casting of an ingot.The alloying element is generally selected from the group consisting of titanium, zirconium, hafnium, carbon, lanthanum oxide, and combinations thereof. In one embodiment, the first workpiece further includes niobium in an amount that is less than about 3 wt.%, preferably from about 1 wt % to about 3 wt.%. In another embodiment, the alloying element is present in an amount that is about 1.2 wt. %, or less. In another embodiment, the alloying element is present in an amount ranging from about 1 wt.% to about 1.5 wt.%. In another embodiment, the first workpiece further includes tungsten in an amount ranging from about 1 to about 30 wt.%.

The first workpiece is thermally treated and subjected to thermo-mechanical forces in a first direction, so that a second workpiece forms. The thermal treatment of the first workpiece is generally done at a temperature that is at least about 2100°F (about 1148°C) and preferably from about 2500°F (about 1371°C) to about 3000 °F (1648°C).

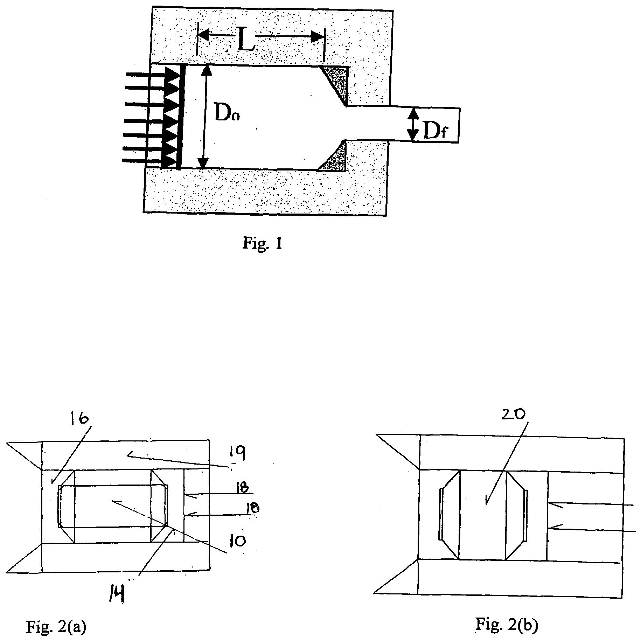

The thermally treated first workpiece is subjected to any thermomechanical treatment, which when practiced in accordance to the invention, produces a plate that is useful in an X-ray target. In one embodiment, the first workpiece is a billet or an ingot and the first workpiece is thermo-mechanically treated by extruding the billet or the ingot to a ratio of reduction (Dₒ:D_{f}) in a cross-sectional area ranging from about 3:1 through about 4:1. More particularly, referring to Fig. 1, the billet/ingot is extruded along length "L" to a suitable ratio of reduction (Dₒ:D_{f}). The billet length can be vary and preferably is from about 14" (about 36 cm) to about 32" (about 82 cm).

The second workpiece is then thermally treated and subjected to thermo-mechanical forces in a second direction that is different from the first direction. The second workpiece is subjected to upset forging. The thermal treatment of the first workpiece is generally done at a temperature that is at least about 2100°F (about 1148°C) and preferably from about 2500°F (about 1371°C) to about 3000 °F (1648°C).

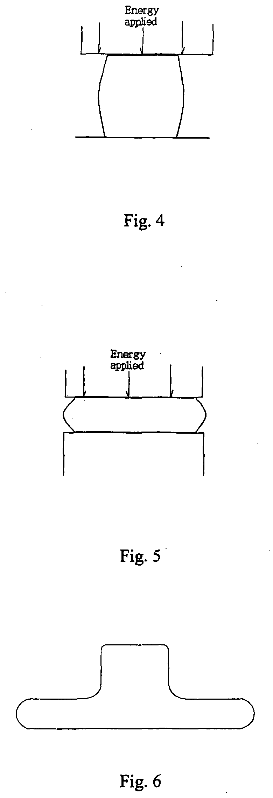

The thermally treated second workpiece is subjected to a thermo-mechanical treatment, which when practiced in accordance to the invention, produces a plate that is useful in an X-ray target. The second workpiece is upset forged by a closed die forging process with a closed die that is dimensioned to form a plate. The closed die is further dimensioned to include a mold for a stem (shown in Fig. 6) so that the plate formed by the process further includes a stem. As such, the invention encompasses a member made by the process of the invention, in which the member has a plate and a stem attached to the plate.

Referring to Figs. 2(a) and 2(b), Fig. 2(a) shows the first workpiece (10) at the start of the upset forging process in which the workpiece is placed in the press liner (12), between centering disks (14,16) and within an extrusion liner (19), such the moving centering disk (14) applies a main ram tonnage (18) against the stationary centering disk (16).

Fig. 2(b) depicts the end of the forming process in which the workpiece (10) has been subjected to thermo-mechanical forces thereby forming a forged workpiece (or forged billet (20)). As a comparative and as shown in Figs. 4 and 5, the second workpiece is subjected to hammer-forging instead of upset forging. Fig. 4 shows a workpiece being subjected to hammer forging, and Fig. 5 shows the second workpiece formed from the first workpiece. In this embodiment, the ratio of Dₒ cross-sectional area to D_{f} cross-sectional area preferably ranges from 1:2.0 to 1:2.8.

The thermo-mechanically treated second workpiece is subjected to a recrystallization heat treatment step to form a fully annealed, cross-directionally worked workpiece. This is generally done by through conventional heat treatment methods.

The heat treatment is generally done at a temperature that is at least about 2100°F (about 1148°C) and preferably from about 2500°F (about 1371°C) to about 3000 °F (1648°C).

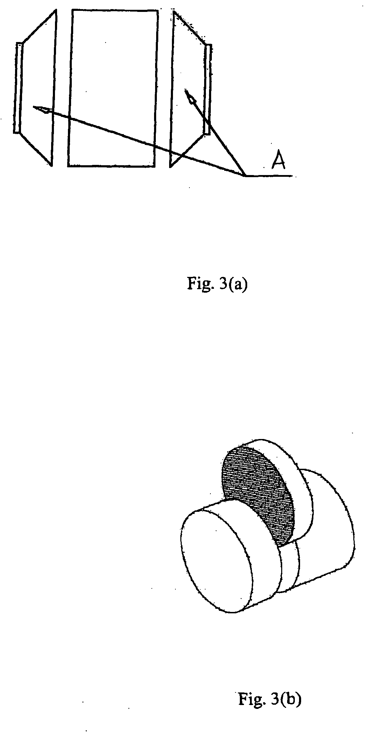

The heat-treated, cross-directionally worked workpiece is then subjected to a slicing step or a machining step, and thereby the cross-directionally worked molybdenum plate forms. The material that does not form the billet during upset forging (the "affected material") is removed by the centering disks (CD), as shown in Fig 3(a) and 4.A plate can be sliced from the billet per the orientation shown in the Fig. 3(b) Advantageously, the entire billet is useful for making plates.

The plate made by the process of the invention has any suitable dimension that enables the plate to be used in a sputtering target. In one preferred embodiment, the plate has a diameter ranging from about 6" (about 15 cm) to about 14 " (about 36 cm) and a thickness/height ranging from about 0.5" (about 1 cm) to about 2" (about 5 cm). In another embodiment, the plate has a diameter ranging from about 1" (about 2.54 cm) to about 14" (about 36 cm) and a thickness/ height ranging from about 1/4" (about 0.6 cm) to about 7" (about 18 cm).

Advantageously, the plate has high temperature Optionally, the plate has a radial strength of at least about 413685438 Pa (60 ksi) when the plate is exposed to a temperature of about 1600°C. When the alloying element includes lanthanum oxide, the plate made by the process of the invention has improved creep resistance, as compared to a plate made without lanthanum oxide. In one embodiment the plate includes a stem. Optionally, a plate is obtained having a cross-directionally worked molybdenum component selected from the group consisting of (i) a molybdenum component containing molybdenum and an alloying element selected from the group consisting of titanium, zirconium, hafnium, carbon, lanthanum oxide, and combinations thereof or (ii) a molybdenum component including molybdenum, niobium and an alloying element selected from the group consisting of titanium, zirconium, hafnium, carbon, lanthanum oxide, and combinations thereof or (iii) a molybdenum component made of molybdenum, tungsten in an amount ranging from about 1 to about 30 wt.% and an alloying element selected from the group consisting of titanium, zirconium, hafnium, carbon, lanthanum oxide, and combinations thereof; in which the plate has a radial strength of at least about 413685438 Pa (60 ksi) when the plate is exposed to a temperature of about 1600°C.

In one embodiment, the stem also includes a cross-directionally worked molybdenum component selected from the group consisting of (i) a molybdenum component containing molybdenum and an alloying element selected from the group consisting of titanium, zirconium, hafnium, carbon, lanthanum oxide, and combinations thereof or (ii) a molybdenum component involving molybdenum, niobium and an alloying element selected from the group consisting of titanium, zirconium, hafnium, carbon, lanthanum oxide, and combinations thereof or (iii) a molybdenum component including molybdenum, tungsten in an amount ranging from about 1 to about 30 wt.% and an alloying element selected from the group consisting of titanium, zirconium, hafnium, carbon, lanthanum oxide, and combinations thereof, in which the stem also has a strength of at least about 413685438 Pa (60 ksi) when the stem is exposed to a temperature of about 1600°C.

## Claims

1. A process for making a cross-directionally worked molybdenum plate, the process comprising:
(a) reducing ammonium molybdate and forming molybdenum metal powder;
(b) consolidating a molybdenum component comprised of molybdenum metal powder and an alloying element to a first workpiece, the alloying element being selected from the group consisting of titanium, zirconium, hafnium, carbon, lanthanum oxide, and combinations thereof;
(c) thermally treating the first workpiece and subjecting the workpiece to thermo-mechanical forces in a first direction, and thereby forming a second workpiece;
(d) thermally treating the second workpiece and subjecting the second workpiece to thermo-mechanical forces in a second direction that is different from the first direction by upset forging by a closed die forging process with a closed die that is dimensioned to form a plate;
(e) subjecting the thermomechanically treated second workpiece to a recrystallization heat treatment step, and thereby forming a heat-treated crossdirectionally worked workpiece; and
(f) subjecting the heat-treated, cross-directionally worked workpiece to a slicing step or a machining step, and thereby forming the cross-directionally worked molybdenum plate,
wherein in step d), the closed die is further dimensioned to include a mold for a stem so that the plate formed by the process in step e) further comprises a stem.

2. The process of Claim 1, wherein the first workpiece further comprises niobium in an amount that is less than about 3 wt.%.

3. The process of Claim 1, wherein the first workpiece further comprises tungsten in an amount ranging from about 1 to about 30 wt.%.

4. The process of Claim 1, wherein the molybdenum component is consolidated into the first workpiece by a powder metallurgical technique.

5. The process of Claim 1, wherein the molybdenum component is consolidated into the first workpiece by an arc casting technique.

6. The process of Claim 5, wherein the arc casting technique is a vacuum arc casting technique.

7. The process of Claim 1, wherein the first workpiece is a billet or an ingot and the first workpiece is thermo-mechanically treated by extruding the billet or the ingot to a ratio of reduction (Do:Df) in a cross-sectional area ranging from about 3:1 through about 4:1.

8. An X-ray target made by the process of Claim 1, wherein the X-ray target comprises a plate and a stem attached to the plate.

9. The process of Claim 1, wherein the alloying element is present in an amount that is about 1.2 wt. %, or less.

10. The process of Claim 1, wherein the alloying element is present in an amount ranging from about 1 wt.% to about 1.5 wt.%.

11. The process of Claim 1, wherein the plate has a diameter ranging from about 2.54 cm to about 36 cm and a thickness/height ranging from about 0.6 cm to about 18 cm.

12. The process of Claim 1, wherein the alloying element comprises lanthanum oxide, and the plate made by the process has improved creep resistance, as compared to a plate made without lanthanum oxide.

## Patentansprüche

1. Verfahren zur Herstellung einer in überkreuzenden Richtungen verarbeiteten Molybdän-Platte, wobei das Verfahren umfasst:
(a) Reduzieren von Ammoniummolybdat und Bilden von Molybdän-Metall-Pulver;
(b) Verfestigen einer aus Molybdän-Metall-Pulver und einem Legierungs-Element gebildeten Molybdän-Komponente zu einem ersten Werkstück, wobei das Legierungs-Element ausgewählt ist aus der Gruppe, bestehend aus Titan, Zirkonium, Hafnium, Kohlenstoff, Lanthanoxid und Kombinationen davon;
(c) Wärme-Behandeln des ersten Werkstücks und Unterziehen des Werkstücks thermo-mechanischen Kräften in eine erste Richtung und dabei Bilden eines zweiten Werkstücks;
(d) Wärme-Behandeln des zweiten Werkstücks und Unterziehen des zweiten Werkstücks thermo-mechanischen Kräften in eine zweite Richtung, die von der ersten Richtung verschieden ist, durch Anstauchen im Gesenk durch ein Gesenkschmiede-Verfahren mit geschlossenem Gesenk, das zur Herstellung einer Platte bemessen ist;
(e) Unterziehen des thermo-mechanisch behandelten zweiten Werkstücks einem Rekristallisations-Wärme-Behandlungs-Schritt, und dabei Bilden eines Wärme-behandelten in überkreuzenden Richtungen verarbeiteten Werkstücks; und
(f) Unterziehen des Wärme-behandelten, in überkreuzenden Richtungen verarbeiteten Werkstücks einem Schneid-Schritt oder einem Fräs-Schritt, und dabei Bilden der in überkreuzenden Richtungen verarbeiteten Molybdän-Platte,
wobei in Schritt d) das geschlossene Gesenk weiterhin bemessen ist, dass eine Form für einen Schaft enthalten ist, so dass die durch das Verfahren in Schritt e) gebildete Platte weiterhin einen Schaft umfasst.

2. Verfahren nach Anspruch 1, wobei das erste Werkstück weiterhin Niob in einer Menge, die weniger als etwa 3 Gew.-% ist, umfasst.

3. Verfahren nach Anspruch 1, wobei das erste Werkstück weiterhin Wolfram in einer Menge im Bereich von etwa 1 bis etwa 30 Gew.-% umfasst.

4. Verfahren nach Anspruch 1, wobei die Molybdän-Komponente in dem ersten Werkstück durch eine Pulver-metallurgische Technik verfestigt wird.

5. Verfahren nach Anspruch 1, wobei die Molybdän-Komponente in dem ersten Werkstück durch eine Bogen-Guss-Technik verfestigt wird.

6. Verfahren nach Anspruch 5, wobei die Bogen-Guss-Technik eine Vakuum-Bogen-Guss-Technik ist.

7. Verfahren nach Anspruch 1, wobei das erste Werkstück ein Rohling oder ein Ingot ist und das erste Werkstück durch Extrudieren des Rohlings oder des Ingots zu einem Reduktions-Verhältnis (D₀:D_{f}) in einem Querschnitts-Gebiet im Bereich von etwa 3:1 bis etwa 4:1 thermo-mechanisch behandelt wird.

8. Röntgen-Target, hergestellt durch das Verfahren nach Anspruch 1, wobei das Röntgen-Target eine Platte und einen an der Platte befestigten Schaft umfasst.

9. Verfahren nach Anspruch 1, wobei das Legierungs-Element in einer Menge vorliegt, die etwa 1,2 Gew.-% oder weniger ist.

10. Verfahren nach Anspruch 1, wobei das Legierungs-Element in einer Menge im Bereich von etwa 1 Gew.-% bis etwa 1,5 Gew.-% vorliegt.

11. Verfahren nach Anspruch 1, wobei die Platte einen Durchmesser im Bereich von etwa 2,54 cm bis etwa 36 cm und eine Dicke/Höhe im Bereich von etwa 0,6 cm bis etwa 18 cm aufweist.

12. Verfahren nach Anspruch 1, wobei das Legierungs-Element Lanthanoxid umfasst, und die durch das Verfahren hergestellte Platte verbesserte Kriechfestigkeit aufweist, wenn mit einer ohne Lanthanoxid hergestellten Platte verglichen.

## Revendications

1. Procédé pour produire une plaque de molybdène travaillée transversalement, lequel procédé comprend .
(a) la réduction de molybdate d'ammonium et la formation de poudre de molybdène métallique ;
(b) la consolidation d'un composant de molybdène constitué de poudre de molybdène métallique et d'un élément d'alliage en une première pièce de fabrication, l'élément d'alliage étant choisi dans l'ensemble constitué par le titane, le zirconium, le hafnium, le carbone, l'oxyde de lanthane, et leurs combinaisons ;
(c) le traitement thermique de la première pièce de fabrication et la soumission de la pièce de fabrication à des forces thermomécaniques dans une première direction, ce qui forme ainsi une deuxième pièce de fabrication ;
(d) le traitement thermique de la deuxième pièce de fabrication et la soumission de la deuxième pièce de fabrication à des forces thermomécaniques dans une deuxième direction qui est différente de la première direction par refoulage au moyen d'un traitement de forgeage en matrice fermée avec une matrice fermée qui est dimensionnée pour former une plaque ;
(e) la soumission de la deuxième pièce de fabrication traitée thermo-mécaniquement à une étape de traitement thermique de recristallisation, ce qui forme ainsi une pièce de fabrication travaillée transversalement et traitée à la chaleur ; et
(f) la soumission de la pièce de fabrication travaillée transversalement et traitée à la chaleur à une étape de tranchage ou à une étape d'usinage, ce qui forme ainsi la plaque de molybdène travaillée transversalement,
dans lequel, dans l'étape d), la matrice fermée est en outre dimensionnée pour comprendre un moule pour une tige de sorte que la plaque formée par le traitement de l'étape e) comprenne en outre une tige.

2. Procédé selon la revendication 1, dans lequel la première pièce de fabrication comprend en outre du niobium en une quantité qui est inférieure à environ 3 % en poids.

3. Procédé selon la revendication 1, dans lequel la première pièce de fabrication comprend en outre du tungstène en une quantité située dans la plage allant d'environ 1 à environ 30 % en poids.

4. Procédé selon la revendication 1, dans lequel le composant molybdène est consolidé en la première pièce de fabrication par une technique de métallurgie des poudres.

5. Procédé selon la revendication 1, dans lequel le composant molybdène est consolidé en la première pièce de fabrication par une technique de coulée à l'arc.

6. Procédé selon la revendication 5, dans lequel la technique de coulée à l'arc est une technique de coulée à l'arc sous vide.

7. Procédé selon la revendication 1, dans lequel la première pièce de fabrication est une billette ou un lingot et la première pièce de fabrication est traitée thermo-mécaniquement par extrusion de la billette ou du lingot jusqu'à un rapport de réduction (D₀/D_{f}) dans la zone en coupe transversale situé dans la plage allant d'environ 3/1 à environ 4/1.

8. Cible pour rayons X produite par le procédé de la revendication 1, laquelle cible pour rayons X comprend une plaque et une tige attachée à la plaque.

9. Procédé selon la revendication 1, dans lequel l'élément d'alliage est présent en une quantité qui est d'environ 1,2 % en poids ou moins.

10. Procédé selon la revendication 1, dans lequel l'élément d'alliage est présent en une quantité située dans la plage allant d'environ 1 % en poids à environ 1,5 % en poids.

11. Procédé selon la revendication 1, dans lequel la plaque présente un diamètre situé dans la plage allant de 2,54 cm à environ 36 cm et un rapport épaisseur/hauteur situé dans la plage allant d'environ 0,6 cm à environ 18 cm.

12. Procédé selon la revendication 1, dans lequel l'élément d'alliage comprend de l'oxyde de lanthane, et la plaque produite par le procédé a une meilleure résistance au fluage qu'une plaque produite sans oxyde de lanthane.
